(19) **Europäisches Patentamt European Patent Office Office européen des brevets**

(11) **EP 4 176 101 B1**

(12) **FASCICULE DE BREVET EUROPEEN**

(45) Date de publication et mention de la délivrance du brevet:
**14.05.2025 Bulletin 2025/20**

(21) Numéro de dépôt: **21740148.8**

(22) Date de dépôt: **21.06.2021**

(51) Classification Internationale des Brevets (IPC):
**C23C 16/442** *(2006.01)* **B01J 8/18** *(2006.01)*
**C04B 35/628** *(2006.01)* **C23C 16/26** *(2006.01)*
**C23C 16/44** *(2006.01)* **C23C 16/46** *(2006.01)*
**F27B 15/00** *(2006.01)* **C04B 41/00** *(2006.01)*
**C04B 41/45** *(2006.01)* **C04B 41/81** *(2006.01)*
**F27B 15/10** *(2006.01)* **F27B 15/14** *(2006.01)*

(52) Classification Coopérative des Brevets (CPC):
(C-Sets disponibles)
**C23C 16/442; C04B 35/62839; C04B 35/62884;
C04B 41/009; C04B 41/4584; C04B 41/81;
C23C 16/26; C23C 16/4411; C23C 16/4417;
C23C 16/46; F27B 15/10; F27B 15/14;**
C04B 2235/3217; C04B 2235/5409;
C04B 2235/5436 (Cont.)

(86) Numéro de dépôt international:
**PCT/FR2021/051122**

(87) Numéro de publication internationale:
**WO 2022/003268 (06.01.2022 Gazette 2022/01)**

(54) **DISPOSITIF POUR LE DÉPÔT CHIMIQUE EN PHASE VAPEUR EN LIT FLUIDISÉ**

VORRICHTUNG ZUR CHEMISCHEN WIRBELBETTDAMPFABSCHEIDUNG

APPARATUS FOR FLUIDIZED-BED CHEMICAL VAPOUR DEPOSITION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.07.2020 FR 2006956**

(43) Date de publication de la demande:
**10.05.2023 Bulletin 2023/19**

(73) Titulaires:
• **Safran Ceramics**
  **33185 Le Haillan (FR)**
• **Centre National de la Recherche Scientifique**
  **75016 Paris (FR)**
• **UNIVERSITE DE BORDEAUX**
  **33000 Bordeaux (FR)**

(72) Inventeurs:
• **EL MANSOURI, Amine**
  **33000 BORDEAUX (FR)**
• **BERTRAND, Nathalie, Dominique**
  **33490 SAINT-MAIXANT (FR)**
• **COUTHURES, Sébastien**
  **33140 VILLENAVE-D'ORNON (FR)**
• **GUETTE, Alain, Jean-Michel**
  **33110 LE BOUSCAT (FR)**

(74) Mandataire: **Cabinet Beau de Loménie
158, rue de l'Université
75340 Paris Cedex 07 (FR)**

(56) Documents cités:
FR-A1- 2 931 811     US-A1- 2003 059 615
US-A1- 2010 047 136     US-A1- 2014 127 116

(52) Classification Coopérative des Brevets (CPC):
(Cont.)

C-Sets
**C04B 41/009, C04B 35/10, C04B 38/00;**
**C04B 41/4584, C04B 41/4531, C04B 41/5001**

**Description**

Domaine Technique

La présente invention concerne un dispositif pour le dépôt chimique en phase vapeur en lit fluidisé permettant de stabiliser la température du lit fluidisé au cours du dépôt ainsi que l'utilisation de ce dispositif.

Technique antérieure

La technique de dépôt chimique en phase vapeur en lit fluidisé est connue en soi et permet de revêtir des particules par des revêtements variés adaptés à l'application souhaitée. On connait US 2010/047136 qui divulgue un réacteur à lit fluidisé. Il est toutefois souhaitable d'améliorer le rendement des techniques de dépôt chimique en phase vapeur en lit fluidisé.

Exposé de l'invention

La présente invention concerne un dispositif pour le dépôt chimique en phase vapeur en lit fluidisé, comprenant au moins :

- un réacteur comprenant une zone de traitement dans laquelle le dépôt chimique en phase vapeur en lit fluidisé est destiné à être réalisé à partir d'une phase gazeuse, une zone d'entrée au travers de laquelle la phase gazeuse est destinée à être introduite dans la zone de traitement et une zone de sortie au travers de laquelle la phase gazeuse est destinée à être évacuée de la zone de traitement,
- un système de chauffage configuré pour chauffer la zone de traitement, et
- un système de refroidissement configuré pour refroidir la zone d'entrée,

le dispositif étant caractérisé en ce qu'il comprend en outre un isolant thermique poreux présent dans la zone d'entrée et configuré pour être traversé par la phase gazeuse, ledit isolant thermique poreux présentant une conductivité thermique effective à 20°C inférieure ou égale à 3,5 W.m$^{-1}$.K$^{-1}$.

Dans la suite, l'expression « isolant thermique poreux » sera désignée par « isolant » dans un souci de concision.

On entend par conductivité thermique effective de l'isolant, la conductivité thermique du volume occupé par l'isolant, incluant le gaz interstitiel dans sa porosité, et non pas la conductivité thermique du matériau constituant l'isolant. Le gaz interstitiel présent dans la porosité de l'isolant réduit sa conductivité thermique effective et permet ainsi de limiter la dissipation de chaleur durant le dépôt entre la zone de traitement qui est chauffée et la zone d'entrée qui est refroidie. Cela permet de stabiliser la température du lit fluidisé dans la zone de traitement et de diminuer le phénomène de réduction de la zone utile dans laquelle le dépôt est effectivement effectué, améliorant ainsi le rendement du dépôt.

La conductivité thermique effective de l'isolant thermique poreux $\lambda_{eff}$ rempli d'un gaz de conductivité thermique $\lambda_g$ peut être déterminée par vérification de la relation ci-dessous :

[Math. 1]

$$\frac{\lambda_{eff}}{\lambda_g} = \frac{1 + 2\beta\phi + (2\beta^3 - 0,1\beta)\phi^2 + \phi^3 \times 0,05\exp(4,5\beta)}{(1 - \beta\phi)} \qquad (9)$$

$$\text{avec } \beta = \frac{\lambda_s - \lambda_g}{\lambda_s + 2\lambda_g}$$

Dans la relation ci-dessus, $\lambda_S$ désigne la conductivité thermique du matériau formant l'isolant thermique poreux (i.e. du matériau des grains dans le cas d'un isolant sous forme de lit granulaire), $\Phi$ désigne la fraction volumique solide de l'isolant poreux ou $(1-\Phi)$ désigne le taux de porosité volumique de cet isolant poreux. On peut se référer à la publication GONZO (E.E.). - Chem. Eng. J., 90, p. 299 (2002).

Dans un exemple de réalisation, l'isolant thermique poreux présente une conductivité thermique effective à 20°C inférieure ou égale à 0,42 W.m$^{-1}$.K$^{-1}$.

Une telle caractéristique participe à améliorer davantage encore le rendement de l'opération de dépôt du revêtement.

En particulier, l'isolant thermique poreux peut présenter une conductivité thermique effective à 20°C inférieure ou égale à 0,11 W.m$^{-1}$.K$^{-1}$, par exemple sensiblement égale à 0,11 W.m$^{-1}$.K$^{-1}$.

Dans un exemple de réalisation, le matériau formant l'isolant thermique poreux présente une conductivité thermique à 20°C inférieure ou égale à 40 W.m$^{-1}$.K$^{-1}$. Une telle caractéristique participe à améliorer davantage encore le rendement de l'opération de dépôt du revêtement.

Dans ce cas, l'isolant est formé par un matériau lui-même faiblement conducteur de la chaleur, ce qui stabilise davantage encore la température du lit fluidisé au cours du dépôt du revêtement. Ce cas demeure toutefois optionnel dans la mesure où l'on peut utiliser un matériau ayant une conductivité thermique supérieure pour former l'isolant car la porosité de l'isolant - remplie d'un gaz interstitiel faiblement conducteur de la chaleur - réduit la conductivité thermique effective de l'isolant à une valeur acceptable même si ce dernier est formé par un matériau intrinsèquement relativement conducteur de la chaleur.

En particulier, le matériau formant l'isolant thermique poreux peut présenter une conductivité thermique à 20°C inférieure ou égale à 4 W.m$^{-1}$.K$^{-1}$, par exemple inférieure ou égale à 3 W.m$^{-1}$.K$^{-1}$.

Dans un exemple de réalisation, le taux de porosité volumique de l'isolant thermique poreux est supérieur à 26%, par exemple supérieur ou égal à 32%.

Une telle caractéristique participe avantageusement à réduire davantage encore la conductivité thermique effective de l'isolant, stabilisant davantage encore la température du lit fluidisé au cours du dépôt du revêtement. Dans le cas particulier d'un lit granulaire, de telles valeurs de porosité correspondent à un état de remplissage « vrac » ou non compact.

Dans un exemple de réalisation, l'isolant thermique poreux est un lit granulaire. L'invention vise également un procédé de revêtement de particules mettant en œuvre un dispositif tel que décrit plus haut, comprenant au moins :

- l'introduction de la phase gazeuse dans la zone de traitement au travers de la zone d'entrée et de l'isolant thermique poreux,
- le dépôt d'un revêtement sur les particules présentes dans la zone de traitement par dépôt chimique en phase vapeur en lit fluidisé à partir de la phase gazeuse introduite, et
- la récupération, après le dépôt du revêtement, des particules revêtues.

Dans un exemple de réalisation, la phase gazeuse a une conductivité thermique à 20°C inférieure ou égale à 0,04 W.m$^{-1}$.K$^{-1}$.

Dans un exemple de réalisation, on récupère, après le dépôt du revêtement, un mélange des particules revêtues et des grains du lit granulaire, et l'on sépare les particules revêtues desdits grains.

Brève description des dessins

[Fig. 1] La figure 1 illustre, de manière schématique et partielle, un dispositif pour la mise en œuvre d'un dépôt chimique en phase vapeur en lit fluidisé hors invention.

[Fig. 2] La figure 2 représente l'évolution de la température moyenne du lit fluidisé obtenue lors d'un dépôt réalisé avec le dispositif de la figure 1.

[Fig. 3] La figure 3 représente la perte de charge normalisée du gaz de fluidisation en fonction de sa vitesse lors de la mise en œuvre d'un dépôt avec le dispositif de la figure 1.

[Fig. 4] La figure 4 compare les hauteurs du lit de particules obtenues avant et après dépôt pour différentes vitesses du gaz de fluidisation lorsque le dispositif de la figure 1 est mis en œuvre.

[Fig. 5] La figure 5 illustre, de manière schématique et partielle, un dispositif pour la mise en œuvre d'un dépôt chimique en phase vapeur en lit fluidisé selon l'invention.

[Fig. 6] La figure 6 représente l'évolution de la température moyenne du lit fluidisé obtenue lors d'un dépôt réalisé avec le dispositif de la figure 5.

Description des modes de réalisation

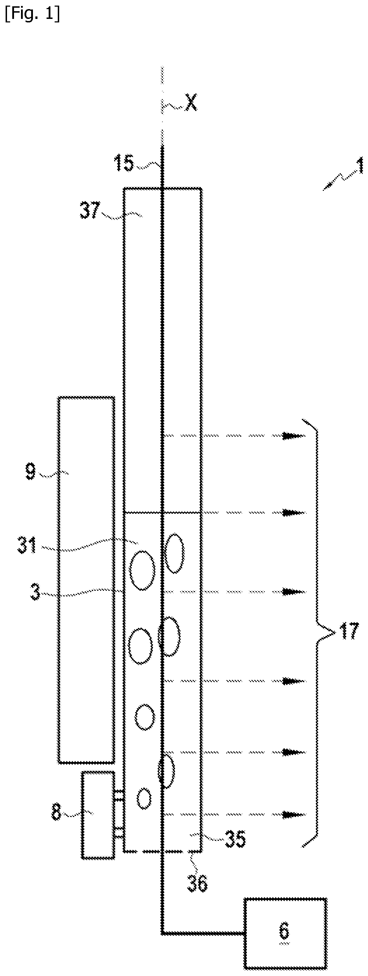

On va décrire en lien avec la figure 1 la structure d'un dispositif 1 hors invention apte à réaliser un revêtement de particules par dépôt chimique en phase vapeur en lit fluidisé. Le dépôt chimique en phase vapeur en lit fluidisé est une technique connue en soi.

Le dispositif 1 comprend un réacteur 3 défini par une paroi pouvant être en quartz ou en Inconel®. Le réacteur 3 comprend une zone de traitement 31 dans laquelle le dépôt chimique en phase vapeur en lit fluidisé est destiné à être réalisé à partir d'une phase gazeuse. Le réacteur 3 comprend en outre une zone d'entrée 35 en communication avec une source 6 de phase gazeuse au travers de laquelle la phase gazeuse comprenant le précurseur du revêtement à former est destinée à être introduite dans la zone de traitement 31. La zone d'entrée 35 comprend un diffuseur poreux 36 assurant la diffusion de la phase gazeuse dans le réacteur 3. La phase gazeuse provenant de la source 6 de phase gazeuse est introduite dans le réacteur 3 au travers du diffuseur 36. Le réacteur 3 comprend en outre une zone de sortie 37 au travers de laquelle la phase gazeuse est destinée à être évacuée de la zone de traitement 31 vers l'extérieur du réacteur 3. La zone de sortie 37 est en communication avec un système de pompage (non représenté) afin d'assurer la réalisation d'un vide dans le réacteur 3. La phase gazeuse provenant de la source 6 de phase gazeuse passe d'abord par la zone d'entrée 35, puis par la zone de traitement 31 et est ensuite évacuée à l'extérieur du réacteur 3 en traversant la zone de sortie 37. Le réacteur 3 peut s'étendre le long d'un axe X vertical. Les zones d'entrée 35, de traitement 31 et de sortie 37 se succèdent le long de l'axe X. La zone de traitement 31 est présente entre la zone d'entrée 35 et la zone de sortie 37.

Le lit de particules à traiter repose initialement sur le diffuseur 36 et la phase gazeuse est injectée sous le diffuseur 36 et traverse le lit de particules du bas vers le haut. Ce mouvement ascendant de gaz permet de supporter le poids du lit de particules et garantit l'état de fluidisation de ce dernier.

Le dispositif 1 comprend un système de chauffage 9 configuré pour chauffer la zone de traitement 31 à une température permettant la formation du revêtement sur les particules à partir du précurseur contenu dans la phase gazeuse. Le système de chauffage 9 peut être configuré pour réaliser un chauffage résistif ou en variante un chauffage inductif. Le système de chauffage 9 peut être disposé autour de toute la circonférence de la zone de traitement 31 ou autour d'une partie seulement de cette dernière. Des thermocouples 17 situés à l'intérieur d'une gaine 15 centrée au niveau du réacteur 3 sont disposés à différentes positions dans le réacteur 3 et permettent de suivre l'évolution de la température à différentes hauteurs dans le lit fluidisé. Le dispositif 1 comprend en outre un système de refroidissement 8 configuré pour refroidir la zone d'entrée 35. Le système de refroidissement 8 peut comprendre un circuit dans lequel circule un fluide de refroidissement régulé à une température inférieure ou égale à 50°C, par exemple à 20°C. Le système de refroidissement 8 peut être sous la forme de brides de refroidissement. Le fluide de refroidissement peut être de l'eau. Le système de refroidissement 8 permet d'éviter que la température du diffuseur 36 ne soit trop élevée afin d'éviter un colmatage de ce dernier par un dépôt produit à partir de la phase gazeuse. Le système de chauffage 9 est décalé du système de refroidissement 8 le long de l'axe X du réacteur 3. Le système de chauffage 9 est décalé du diffuseur 36 le long de l'axe X du réacteur 3. La phase gazeuse introduite dans le réacteur 3 pour la réalisation du revêtement est fonction de la nature du revêtement à obtenir et il va des connaissances générales de l'homme du métier de la choisir et de choisir les conditions de dépôt associées, en termes de température, pression et débit. La phase gazeuse comprend typiquement un gaz porteur, inerte, comme du diazote. On peut utiliser des précurseurs gazeux dans les conditions standards, auquel cas ils peuvent être mélangés au gaz porteur avant leur introduction dans le réacteur 3. On peut encore utiliser des précurseurs liquides dans les conditions standards, auquel cas le gaz porteur peut buller dans le précurseur liquide pour s'en enrichir et être ensuite introduit dans le réacteur 3.

Dans l'exemple non limitatif d'un dépôt d'un revêtement en pyrocarbone, on peut utiliser du diazote en tant que gaz porteur. Le débit d'introduction du gaz porteur dans un réacteur 3 tel que schématisé à la figure 1 ayant 5 centimètres de diamètre et de 1 mètre de hauteur peut être compris entre 500 centimètres cubes standards par minute et 3000 centimètres cubes standards par minute, par exemple entre 750 centimètres cubes standards par minute et 1250 centimètres cubes standards par minute. La température imposée dans la zone de traitement 31 peut être comprise entre 850°C et 1100°C, par exemple entre 925°C et 1000°C. Le système de chauffage 9 peut être positionné à 15 centimètres au-dessus du diffuseur 36. On peut utiliser, dans ce cas non limitatif, du propane en tant que précurseur du pyrocarbone à déposer. Son débit peut être compris entre 5% et 30% du débit du gaz porteur, par exemple entre 10% et 20% du débit du gaz porteur. A titre d'exemple, on peut citer d'autres précurseurs pour le pyrocarbone, comme des précurseurs gazeux tels que les mélanges méthane/propane ou le gaz naturel. On peut encore citer des précurseurs liquides comme le toluène, le cyclohexane ou l'éthanol.

Le dépôt réalisé à l'aide du dispositif 1 de la figure 1 donne des résultats satisfaisants. Néanmoins, les inventeurs ont constaté que la température moyenne du lit fluidisé diminue au cours du dépôt. En effet, le maintien d'une température modérée au niveau du diffuseur 36 afin d'éviter un bouchage par un dépôt provenant de la phase gazeuse est tel que la zone d'entrée 35 refroidie constitue une zone de dissipation de la chaleur. Les échanges thermiques entre la paroi du réacteur 3 et le lit fluidisé se font essentiellement par convection particulaire et rayonnement. Ainsi, le lit fluidisé cède facilement de la chaleur à la paroi du réacteur 3 dans la zone d'entrée 35. Cette dissipation de chaleur conduit à une baisse de la température moyenne au sein du lit fluidisé durant le dépôt et à une réduction de la zone utile où le dépôt est effectivement effectué, ce qui aboutit à une baisse du rendement.

Les résultats expérimentaux obtenus par les inventeurs qui ont permis de mettre en œuvre ce phénomène sont détaillés ci-dessous.

Les inventeurs ont réalisé une opération de dépôt de carbone sur une poudre d'alumine poreuse ayant les caractéristiques suivantes : les particules de la poudre appartiennent aux catégories A ou B de Geldart, le diamètre d50 des particules est compris entre 4 μm et 20 μm, la surface spécifique de ces dernières est de 200 m$^2$/g et le taux de vide initial du lit fixe constitué par ces particules brutes (avant dépôt). était égal à 80%.

Le carbone a été déposé à partir de propane avec une température de consigne dans la zone de traitement 31 de 1000°C et une pression dans le réacteur 3 de 400 mbars. La masse initiale des particules mises en œuvre durant le dépôt était de 290 grammes, correspondant à une hauteur initiale du lit fluidisé de 23,3 cm. Le débit de propane était maintenu à 200 centimètres cubes standards par minute et le débit d'azote à 600 centimètres cubes standards par minute.

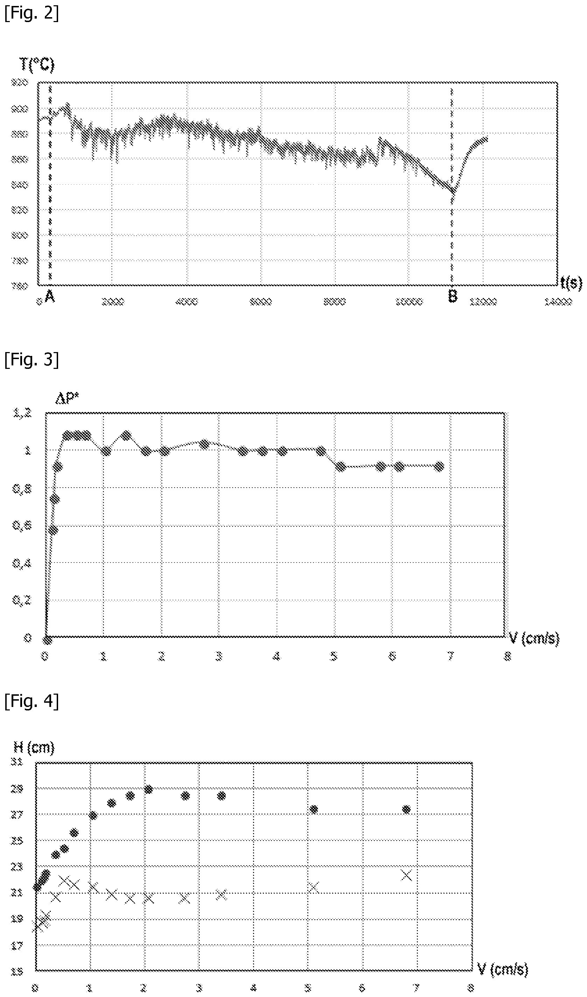

L'évolution de la température moyenne du lit fluidisé au cours du dépôt est fournie à la figure 2. Sur cette figure, l'injection de propane est matérialisée par la ligne pointillés « A » et l'arrêt de l'injection de propane par la ligne pointillés « B ». On constate que la température moyenne au sein du lit fluidisé tend à diminuer au cours du dépôt. Le volume actif du lit de particules a tendance à se réduire, ce qui conduit à une baisse du rendement du dépôt. Les inventeurs ont constaté que ces instabilités thermiques s'accompagnent d'une diminution de la température externe de la paroi du tube et d'une augmentation de la température du fluide de refroidissement circulant dans le système de refroidissement 8. Le suivi thermique montre aussi qu'après l'arrêt du propane, l'ensemble des perturbations thermiques s'atténue et la température du lit fluidisé tend à augmenter à nouveau sans toutefois revenir à sa valeur avant dépôt.

La figure 3 montre l'évolution de la perte de charge normalisée (ΔP*) subie par le gaz en fonction de sa vitesse.

ΔP* est égal au rapport entre la perte de charge mesurée subie par le gaz à la traversée du lit fluidisé et la valeur théorique de cette perte de charge. La valeur théorique est calculée à partir du poids du lit de particules rapporté à sa surface. selon la relation :

[Math. 2]

$$\Delta P^* = \frac{\Delta P_{experimental}}{\Delta P_{théorique}} \quad et \quad \Delta P_{théorique} = \frac{m_{lit}\, g}{S}$$

La valeur de ΔP* constitue donc une manière de vérifier la qualité du régime de fluidisation. Une valeur de ΔP* égale à 1 indique que toutes les particules sont dans un état de fluidisation pouvant être qualifié d'homogène.

On constate que l'on obtient une valeur de ΔP* proche de 1 qui indique que les poudres après dépôt conservent une capacité à fluidiser de manière homogène. Il a en revanche été constaté une baisse de la hauteur expansée du lit de poudres après dépôt (voir figure 4). La hauteur du lit de poudres au minimum de fluidisation est réduite d'environ 13 %. La figure 4 fait figurer avec des croix les hauteurs du lit de particules après le dépôt et avec des cercles les hauteurs du lit de particules avant dépôt.

L'ensemble de ces résultats confirme le phénomène de dissipation de la chaleur par convection particulaire au niveau de la zone d'entrée 35 refroidie.

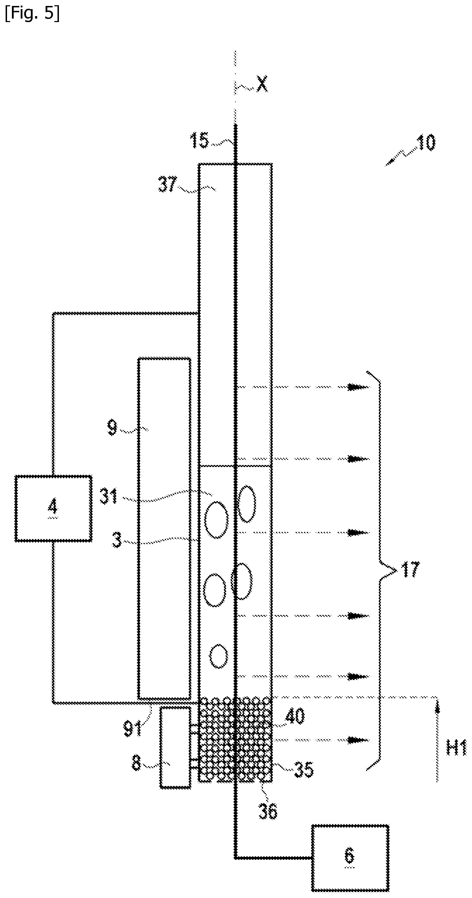

Suite à cette constatation, les inventeurs ont proposé une évolution du dispositif 1 de la figure 1 permettant de réduire les échanges thermiques dans la zone d'entrée 35. Un schéma du dispositif 10 selon l'invention qui répond à ce problème est fourni à la figure 5.

Le dispositif 10 comprend les mêmes éléments que le dispositif 1 qui sont référencés de la même manière. Afin de réduire la dissipation de chaleur au niveau de la zone d'entrée 35 refroidie, l'invention propose de munir le réacteur 3 d'un isolant thermique poreux 40 qui présente, comme indiqué plus haut, une conductivité thermique effective relativement faible. La porosité de l'isolant 40 lui permet d'être traversé par la phase gazeuse et participe à la réduction de sa conductivité thermique effective. Le taux de porosité volumique de l'isolant 40 peut être compris entre 26% et 48%, par exemple compris entre 34% et 40%, par exemple sensiblement égal à 37%. La porosité de l'isolant 40 peut présenter une forme tortueuse. L'isolant 40 est présent entre le diffuseur 36 et la zone de traitement 31. L'isolant 40 peut être présent sur plus de 50%, voire sur au moins 75%, voire sur sensiblement l'intégralité de la hauteur de la zone d'entrée 35. L'isolant 40 peut être présent sur plus de 50%, voire sur au moins 75%, voire sur sensiblement l'intégralité de la hauteur sur laquelle s'étend le système de refroidissement 8. L'isolant 40 peut s'étendre depuis le diffuseur 36 au moins jusqu'au niveau de la partie inférieure 91 du système de chauffage 9 qui est présente à la hauteur $H_1$. La partie inférieure 91 du système de chauffage 9 correspond à l'extrémité du système de chauffage 9 située du côté de la zone d'entrée 35. L'homme du métier veillera toutefois à ce que l'isolant 40 ne s'étende pas trop haut au-delà de la partie inférieure 91 du système de chauffage 9 afin d'éviter que l'isolant 40 ne soit soumis à une température trop élevée qui conduirait à un dépôt provenant de la phase gazeuse colmatant sa porosité et entravant la circulation de la phase gazeuse. L'homme du métier sait grâce à ses connaissances générales déterminer la hauteur sur laquelle doit s'étendre l'isolant 40 de sorte à obtenir l'avantage recherché. L'homme du métier pourra par exemple choisir la hauteur de l'isolant 40 de sorte à obtenir une baisse maximale de la température moyenne du lit fluidisé de 20°C au bout de 2 heures de dépôt. Comme indiqué plus haut, le matériau formant l'isolant 40 peut ou non être conducteur thermique. On peut avantageusement utiliser un matériau faiblement conducteur de la chaleur pour constituer l'isolant 40, comme un matériau céramique tel que la zircone. La conductivité thermique à 20°C du matériau formant l'isolant 40 peut être comprise entre 0,15 W.m$^{-1}$.K$^{-1}$ et 418 W.m$^{-1}$.K$^{-1}$, par exemple entre 0,15 W.m$^{-1}$.K$^{-1}$ et 40 W.m$^{-1}$.K$^{-1}$, par exemple entre 0,15 W.m$^{-1}$.K$^{-1}$ et 4 W.m$^{-1}$.K$^{-1}$, par exemple entre 0,15 W.m$^{-1}$.K$^{-1}$ et 3 W.m$^{-1}$.K$^{-1}$. L'isolant 40 peut être sous la forme d'un lit granulaire. Dans ce cas, l'isolant 40 est formé par un empilement de grains. Les grains formant l'isolant 40 peuvent être empilés en vrac (empilement non régulier). L'isolant 40 peut être formé d'un matériau distinct des particules à revêtir. On pourrait en variante utiliser un isolant 40 formé d'un bloc fritté partiellement, conservant une porosité ouverte suffisante pour laisser passer la phase gazeuse tout en présentant la conductivité thermique effective souhaitée. Bien entendu, l'homme du métier veillera à choisir l'isolant 40 de sorte à ce qu'il demeure fixe lors du passage de la phase gazeuse, que les particules à revêtir ne se logent dans sa porosité et qu'il n'entraîne pas une perte de charge notable du gaz de fluidisation. Il va des connaissances générales de l'homme du métier de choisir la densité du matériau formant l'isolant 40 et sa porosité de sorte à répondre à ces conditions. On peut par exemple utiliser un lit granulaire formé par des grains en vrac ayant un diamètre moyen d50 inférieur ou égal à 10 mm, par exemple compris entre 0,5 $\mu$m et 10 mm, et une masse volumique supérieure ou égale à 3 g/cm$^3$, par exemple comprise entre 3,2 g/cm$^3$ et 9 g/cm$^3$. Dans le cas de l'exemple de réacteur 3 décrit ci-dessus ayant un diamètre de 5 centimètres et une hauteur de 1 mètre, on peut par exemple utiliser un empilement en vrac de billes de zircone ayant un diamètre moyen d50 égal à 1 mm pour constituer l'isolant 40.

Comme habituellement réalisé dans les procédés de dépôt chimique en phase vapeur en lit fluidisé, on veillera à obtenir un phénomène de fluidisation durant le dépôt. Pour permettre le suivi de la fluidisation, le dispositif 10 comprend un capteur 4 de pression différentielle, permettant l'évaluation de la perte de charge du gaz à la traversée du lit. L'homme du métier peut avantageusement maintenir cette perte de charge à une valeur proche (+/- 20%) du rapport entre le poids du lit et la section du réacteur 3 afin de garantir l'état de fluidisation. L'homme du métier peut aussi veiller à avoir une relative homogénéité de température à l'intérieur du lit. Cette propriété thermique, caractéristique des lits fluidisés fonctionnant de manière optimale, est obtenue par la présence de bulles qui assurent une excellente agitation des particules à revêtir. Les thermocouples 17 permettent de contrôler l'iso-thermicité du lit. La qualité de la fluidisation peut donc être évaluée à partir de l'écart maximal des températures affichées par les thermocouples. Par exemple, l'homme du métier pourra effectuer le dépôt avec un écart maximal de température inférieur ou égal à 20°C, pour des dépôts à température élevée (supérieure à 800°C).

Le revêtement peut être obtenu par dépôt chimique en phase vapeur à partir d'une phase gazeuse. La phase gazeuse peut présenter une conductivité thermique à 20°C inférieure ou égale à 0,04 W.m$^{-1}$.K$^{-1}$, par exemple inférieure ou égale à 0,035 W.m$^{-1}$.K$^{-1}$. La conductivité thermique de la phase gazeuse peut être comprise entre 0,01 W.m$^{-1}$.K$^{-1}$ et 0,04 W.m$^{-1}$.K$^{-1}$, par exemple entre 0,01 W.m$^{-1}$.K$^{-1}$ et 0,035 W.m$^{-1}$.K$^{-1}$. On obtient après le dépôt des particules comprenant un cœur et un revêtement de surface enrobant le cœur, ce revêtement étant obtenu par dépôt en phase vapeur en lit fluidisé. Les particules sont dites « cœur-écorce » (ou « core-shell » dans la littérature anglo-saxonne). Les particules à revêtir peuvent être de toutes sortes, par exemple en matériau céramique, en carbone ou en matériau métallique. Le revêtement déposé peut être de toute sorte, par exemple céramique ou carbone ou métallique, selon l'application souhaitée. Les dimensions et la forme des particules peuvent varier selon l'application souhaitée. Les particules à revêtir peuvent appartenir aux catégories A ou B de Geldart. Le revêtement déposé peut être mono-couche ou multicouches en changeant la nature du précurseur entre le dépôt des différentes couches afin de déposer des couches de nature chimique différente. Les particules revêtues à l'aide du procédé selon l'invention peuvent être utilisés dans différentes applications, constituant par exemple des catalyseurs, ou des adjuvants de frittage.

Un essai a été mené pour revêtir la poudre d'alumine poreuse détaillée précédemment en utilisant cette fois-ci l'exemple de dispositif 10 selon l'invention illustré à la figure 5, les autres conditions opératoires étant conservées.

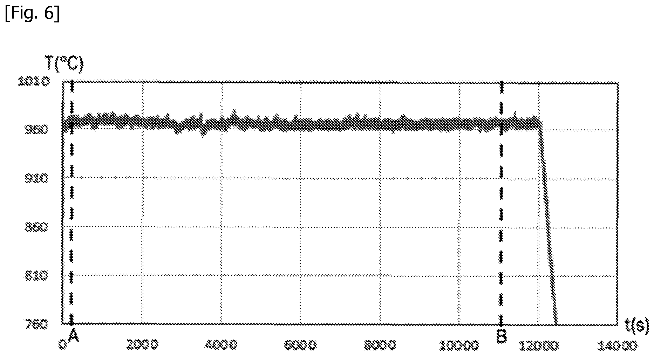

Le suivi de la température moyenne du lit fluidisé au cours du dépôt est fourni à la figure 6. Sur cette figure, l'injection de propane est matérialisée par la ligne pointillés « A » et l'arrêt de l'injection de propane par la ligne pointillés « B ». On constate que la mise en œuvre de l'isolant 40 conduit à une grande stabilité thermique du lit fluidisé au cours de l'opération de dépôt et à un rendement de dépôt amélioré. Après dépôt du revêtement, les particules revêtues sont extraites du réacteur 3.

Lorsque l'isolant 40 est sous la forme d'un lit granulaire, il peut s'avérer nécessaire de réaliser une étape de séparation des particules revêtues des grains formant l'isolant 40. Différentes méthodes sont envisageables pour cela. On peut en particulier réaliser un tamisage de sorte à séparer les particules revêtues des grains du fait de leur différence de taille ou de forme. Dans le cas où les particules revêtues sont séparées des grains par tamisage, on pourra avantageusement choisir des grains de diamètre moyen D50 supérieur ou égal à 0,5 $\mu$m. En variante, on peut attirer magnétiquement les particules revêtues ou les grains afin de procéder à leur séparation.

L'expression « compris(e) entre ... et ... » doit se comprendre comme incluant les bornes.

**Revendications**

1.   Dispositif (10) pour le dépôt chimique en phase vapeur en lit fluidisé, comprenant au moins :

- un réacteur (3) comprenant une zone de traitement (31) dans laquelle le dépôt chimique en phase vapeur en lit fluidisé est destiné à être réalisé à partir d'une phase gazeuse, une zone d'entrée (35) au travers de laquelle la phase gazeuse est destinée à être introduite dans la zone de traitement et une zone de sortie (37) au travers de laquelle la phase gazeuse est destinée à être évacuée de la zone de traitement,
- un système de chauffage (9) configuré pour chauffer la zone de traitement, et
- un système de refroidissement (8) configuré pour refroidir la zone d'entrée,

le dispositif étant **caractérisé en ce qu'**il comprend en outre un isolant (40) thermique poreux présent dans la zone d'entrée et configuré pour être traversé par la phase gazeuse, ledit isolant thermique poreux présentant une conductivité thermique effective à 20°C inférieure ou égale à 3,5 $W.m^{-1}.K^{-1}$, et **en ce que** la porosité de l'isolant présente une forme tortueuse.

2. Dispositif (10) selon la revendication 1, dans lequel l'isolant (40) thermique poreux présente une conductivité thermique effective à 20°C inférieure ou égale à 0,42 $W.m^{-1}.K^{-1}$.

3. Dispositif (10) selon l'une quelconque des revendications 1 ou 2, dans lequel le matériau formant l'isolant (40) thermique poreux présente une conductivité thermique à 20°C inférieure ou égale à 40 $W.m^{-1}.K^{-1}$.

4. Dispositif (10) selon l'une quelconque des revendications 1 à 3, dans lequel l'isolant (40) thermique poreux est un lit granulaire.

5. Dispositif (10) selon l'une quelconque des revendications 1 à 4, dans lequel le taux de porosité volumique de l'isolant thermique poreux est supérieur à 26%.

6. Procédé de revêtement de particules mettant en œuvre un dispositif (10) pour le dépôt chimique en phase vapeur en lit fluidisé, le dispositif comprenant au moins :

- un réacteur (3) comprenant une zone de traitement (31) dans laquelle le dépôt chimique en phase vapeur en lit fluidisé est destiné à être réalisé à partir d'une phase gazeuse, une zone d'entrée (35) au travers de laquelle la phase gazeuse est destinée à être introduite dans la zone de traitement et une zone de sortie (37) au travers de laquelle la phase gazeuse est destinée à être évacuée de la zone de traitement,
- un système de chauffage (9) configuré pour chauffer la zone de traitement, et
- un système de refroidissement (8) configuré pour refroidir la zone d'entrée,

le dispositif comprenant en outre un isolant (40) thermique poreux présent dans la zone d'entrée et configuré pour être traversé par la phase gazeuse, ledit isolant thermique poreux présentant une conductivité thermique effective à 20°C inférieure ou égale à 3,5 $W.m^{-1}.K^{-1}$,
le procédé comprenant au moins :

- l'introduction de la phase gazeuse comprenant un précurseur du revêtement à former dans la zone de traitement (31) au travers de la zone d'entrée (35) et de l'isolant (40) thermique poreux,
- le dépôt d'un revêtement sur les particules présentes dans la zone de traitement par dépôt chimique en phase vapeur en lit fluidisé à partir de la phase gazeuse introduite, et
- la récupération, après le dépôt du revêtement, des particules revêtues.

7. Procédé selon la revendication 6, dans lequel la phase gazeuse a une conductivité thermique à 20°C inférieure ou égale à 0,04 $W.m^{-1}.K^{-1}$.

8. Procédé selon la revendication 6 ou 7 rattachées à la revendication 4, dans lequel on récupère, après le dépôt du revêtement, un mélange des particules revêtues et des grains du lit granulaire, et dans lequel on sépare les particules revêtues desdits grains.

**Patentansprüche**

1. Vorrichtung (10) zur chemischen Gasphasenabscheidung in Wirbelbett, mindestens umfassend:

- einen Reaktor (3), umfassend einen Behandlungsbereich (31), in dem die chemische Dampfabscheidung in Wirbelbett aus einer Gasphase durchgeführt werden soll, einen Einlassbereich (35), durch den die Gasphase in den Behandlungsbereich eingeleitet werden soll, und einen Auslassbereich (37), durch den die Gasphase aus dem Behandlungsbereich abgeleitet werden soll,

- ein Heizsystem (9), das konfiguriert ist, um den Behandlungsbereich zu erwärmen, und
- ein Kühlsystem (8), das konfiguriert ist, um den Einlassbereich zu kühlen, wobei die Vorrichtung **dadurch gekennzeichnet ist, dass** sie ferner eine poröse Wärmeisolierung (40) umfasst, die in dem Einlassbereich vorhanden und konfiguriert ist, um von der Gasphase durchströmt zu werden, wobei die poröse Wärmeisolierung eine effektive Wärmeleitfähigkeit bei 20 °C von weniger als oder gleich wie 3,5 $W.m^{-1}.K^{-1}$ aufweist, und dass die Porosität der Isolierung eine gewundene Form aufweist.

**2.** Vorrichtung (10) nach Anspruch 1, wobei die poröse Wärmeisolierung (40) eine effektive Wärmeleitfähigkeit bei 20°C von weniger als oder gleich wie 0,42 $W.m^{-1}.K^{-1}$ aufweist.

**3.** Vorrichtung (10) nach einem der Ansprüche 1 oder 2, wobei das Material, das die poröse Wärmeisolierung (40) bildet, eine Wärmeleitfähigkeit bei 20 °C von weniger als oder gleich wie 40 $W.m^{-1}.K^{-1}$ aufweist.

**4.** Vorrichtung (10) nach einem der Ansprüche 1 bis 3, wobei die poröse Wärmeisolierung (40) ein Granulatbett ist.

**5.** Vorrichtung (10) nach einem der Ansprüche 1 bis 4, wobei die Volumenporositätsrate der porösen Wärmeisolierung größer als 26 % ist.

**6.** Beschichtungsverfahren von Partikeln, wobei eine Vorrichtung (10) zur chemischen Dampfabscheidung in einem Wirbelbett eingesetzt wird, die Vorrichtung mindestens umfassend:

- einen Reaktor (3), umfassend einen Behandlungsbereich (31), in dem die chemische Dampfabscheidung in Wirbelbett aus einer Gasphase durchgeführt werden soll, einen Einlassbereich (35), durch den die Gasphase in den Behandlungsbereich eingeleitet werden soll, und einen Auslassbereich (37), durch den die Gasphase aus dem Behandlungsbereich abgeleitet werden soll,
- ein Heizsystem (9), das konfiguriert ist, um den Behandlungsbereich zu erwärmen, und
- ein Kühlsystem (8), das konfiguriert ist, um den Einlassbereich zu kühlen, die Vorrichtung ferner umfassend eine poröse Wärmeisolierung (40), die in dem Einlassbereich vorhanden und konfiguriert ist, um von der Gasphase durchströmt zu werden, wobei die poröse Wärmeisolierung eine effektive Wärmeleitfähigkeit bei 20 °C von weniger als oder gleich wie 3,5 $W.m^{-1}.K^{-1}$ aufweist,

das Verfahren mindestens umfassend:

- Einleiten der Gasphase, umfassend einen Vorläufer der Beschichtung, die in dem Behandlungsbereich (31) gebildet werden soll, durch den Einlassbereich (35) und die poröse Wärmeisolierung (40),
- Abscheiden einer Beschichtung auf den Partikeln, die in dem Behandlungsbereich vorhanden sind, durch chemische Dampfabscheidung in Wirbelbett aus der eingeleiteten Gasphase, und
- Rückgewinnen, nach Abscheiden der Beschichtung, der beschichteten Partikel.

**7.** Verfahren nach Anspruch 6, wobei die Gasphase bei 20°C eine Wärmeleitfähigkeit von weniger als oder gleich wie 0,04 $W.m^{-1}.K^{-1}$ aufweist.

**8.** Verfahren nach Anspruch 6 oder 7, in Verbindung mit Anspruch 4, wobei nach Abscheiden der Beschichtung ein Gemisch aus beschichteten Partikeln und Granulat des Granulatbetts rückgewonnen werden und wobei die beschichteten Partikel von dem Granulat abgetrennt werden.

## Claims

**1.** An apparatus (10) for fluidised-bed chemical vapour deposition, comprising at least:

- a reactor (3) comprising a treatment zone (31) in which the fluidised-bed chemical vapour deposition is intended to be carried out from a gaseous phase, an inlet zone (35) through which the gaseous phase is intended to be introduced into the treatment zone and an outlet zone (37) through which the gaseous phase is intended to be removed from the treatment zone,
- a heating system (9) configured to heat the treatment zone, and
- a cooling system (8) configured to cool the inlet zone,

the apparatus being **characterised in that** it further comprises a porous thermal insulator (40) present in the inlet zone and configured to be passed through by the gaseous phase, said porous thermal insulator having an effective thermal conductivity at 20°C less than or equal to 3.5 $W.m^{-1}.K^{-1}$, and **in that** the porosity of the insulator has a tortuous shape.

2. The apparatus (10) according to claim 1, in which the porous thermal insulator (40) has an effective thermal conductivity at 20°C less than or equal to 0.42 $W.m^{-1}.K^{-1}$.

3. The apparatus (10) according to any one of claims 1 or 2, in which the material forming the porous thermal insulator (40) has a thermal conductivity at 20°C less than or equal to 40 $W.m^{-1}.K^{-1}$.

4. The apparatus (10) according to any one of claims 1 to 3, in which the porous thermal insulator (40) is a granular bed.

5. The apparatus (10) according to any one of claims 1 to 4, in which the volume pore ratio of the porous thermal insulator is greater than 26%.

6. A method for coating particles using an apparatus (10) for fluidised-bed chemical vapour deposition, the apparatus comprising at least:

   - a reactor (3) comprising a treatment zone (31) in which the fluidised-bed chemical vapour deposition is intended to be carried out from a gaseous phase, an inlet zone (35) through which the gaseous phase is intended to be introduced into the treatment zone and an outlet zone (37) through which the gaseous phase is intended to be removed from the treatment zone,
   - a heating system (9) configured to heat the treatment zone, and
   - a cooling system (8) configured to cool the inlet zone,
   the apparatus further comprising a porous thermal insulator (40) present in the inlet zone and configured to be passed through by the gaseous phase, said porous thermal insulator having an effective thermal conductivity at 20°C less than or equal to 3.5 $W.m^{-1}.K^{-1}$,
   the method comprising at least:

      - introducing the gaseous phase comprising a precursor of the coating to be formed into the treatment zone (31) through the inlet zone (35) and the porous thermal insulator (40),
      - depositing a coating on the particles present in the fluidised-bed chemical vapour deposition treatment zone from the gaseous phase introduced, and
      - recovering, after depositing of the coating, the coated particles.

7. The method according to claim 6, in which the gaseous phase has a thermal conductivity at 20°C less than or equal to 0.04 $W.m^{-1}.K^{-1}$.

8. The method according to claim 6 or 7, related to claim 4, in which after the deposition of the coating, a mixture of coated particles and grains from the granular bed are recovered, and in which the coated particles are separated from said grains.

[Fig. 1]

[Fig. 2]

[Fig. 3]

[Fig. 4]

[Fig. 5]

[Fig. 6]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010047136 A

**Littérature non-brevet citée dans la description**

- *Chem. Eng. J.*, 2002, vol. 90, 299